(19) Europäisches Patentamt
European Patent Office
Office européen des brevets

(11) **EP 1 779 124 B1**

(12) **EUROPEAN PATENT SPECIFICATION**

(45) Date of publication and mention
of the grant of the patent:
**12.07.2017 Bulletin 2017/28**

(21) Application number: **05779739.1**

(22) Date of filing: **10.08.2005**

(51) Int Cl.:
*G01R 31/26* (2014.01)      *G01R 27/26* (2006.01)
*G01N 22/00* (2006.01)

(86) International application number:
**PCT/US2005/028254**

(87) International publication number:
**WO 2006/020631 (23.02.2006 Gazette 2006/08)**

(54) **DEVICE AND HANDLING SYSTEM FOR MEASUREMENT OF MOBILITY AND SHEET CHARGE DENSITY IN CONDUCTIVE SHEET MATERIALS**

VORRICHTUNG UND HANDHABUNGSSYSTEM ZUR MESSUNG DER MOBILITÄT UND BLATTLADUNGSDICHTE BEI LEITENDEM BLATTMATERIAL

DISPOSITIF ET SYSTEME DE MANIPULATION PERMETTANT DE MESURER LA MOBILITE ET LA CHARGE DE DENSITE D'UNE FEUILLE DANS DES MATERIAUX DE FEUILLE CONDUCTEURS

(84) Designated Contracting States:
**AT BE BG CH CY CZ DE DK EE ES FI FR GB GR HU IE IS IT LI LT LU LV MC NL PL PT RO SE SI SK TR**

(30) Priority: **11.08.2004 US 915877**
**09.03.2005 US 659847 P**

(43) Date of publication of application:
**02.05.2007 Bulletin 2007/18**

(73) Proprietor: **Lehighton Electronics Inc.**
**Lehighton, PA 18325-0328 (US)**

(72) Inventors:
• **BLEW, Austin, R.**
**Lehighton, PA 18325 (US)**
• **BRONKO, Michael, W.**
**Lehighton, PA 18235 (US)**
• **MURPHY, Steven, C.**
**Pottsville, PA 17901 (US)**
• **NGUYEN, Danh**
**Allentown, PA 18103 (US)**
• **EBERHARDT, Nikolai**
**Bethlehem, Pennsylvenia 18015 (US)**
• **LICINI, Jerome, C.**
**Macungie, PA 18062 (US)**
• **ZUIDERVLIET, William**
**Allentown, PA 18103 (US)**

(74) Representative: **Leonhard, Frank Reimund**
**Leonhard & Partner**
**Patentanwälte**
**Postfach 10 09 62**
**80083 München (DE)**

(56) References cited:
**WO-A1-2004/025713      WO-A2-02/090922**
**JP-A- 4 134 901          JP-A- 56 048 145**
**US-A- 4 087 745          US-A- 4 087 745**
**US-A- 5 179 333          US-A- 5 179 333**
**US-A- 6 100 703          US-A- 6 100 703**
**US-A- 6 164 894          US-A1- 2002 192 056**
**US-B1- 6 771 372        US-B1- 6 771 372**

• **"Novel millimeter-wave near-field resistivity microscope", APPLIED PHYSICS LETTERS, AIP, AMERICAN INSTITUTE OF PHYSICS, MELVILLE, NY, US, vol. 68, no. 11, 11 March 1996 (1996-03-11), pages 1579-1581, XP012014847, ISSN: 0003-6951, DOI: 10.1063/1.116685**

## Description

The invention relates to nondestructive measurement and mapping of materials, using microwaves in the measurement of sheet charge density, and mobility and sheet resistance in semiconductor wafers and flat panel displays.

Existing instruments that employ microwaves in the measurement of sheet resistance in GaAs wafers employ an X-band waveguide configuration with a characteristic impedance of 300 ohms which does not permit accurate measurement of wafers with thin cap layers. Such instruments are discussed in U.S. Patent No. 4,605,893, to Norman Braslau. One disadvantage of these instruments is an inability to separately measure the properties of multiple conducting layers in wafers that contain such layers, e.g. a high-electron-mobility transistor (HEMT) wafer, which contains a two-dimensional (2D) channel layer and a cap layer. Therefore, one must measure the sheet resistance and mobility at temperatures lower than 300 degrees Kelvin, such as at 77 degrees Kelvin, in such existing systems in order to increase the channel-layer mobility relative to the conductance of the cap layer. These instruments also require involved calibration procedures. WO 02/090922 A2 discloses a microwave source module which provides microwave radiation at a frequency of 10 GHz and which is connected through a coupler to a side branch and to a main branch with a circular wave-guide adjustment to set the vertical position of the wave-guide with a mount to hold a sample of test material.

Destructive techniques for measurement of sheet resistance and mobility are also known. However, such techniques necessarily damage the wafers or other material being measured.

A device for nondestructive measurement of mobility and sheet charge density in sheet materials includes a microwave source, a circular waveguide configured to transmit microwaves received from the microwave source to a conductive sheet material, such as a semiconductor wafer or flat panel display, a first detector for receiving the forward microwave power, a second detector for detecting the microwave power reflected from the material, and a third detector for detecting the Hall effect power. A circular waveguide, carrying only the $TE_{11}$ mode, is terminated by the wafer behind which, at a distance of ¼ wavelength, a short is located. Perpendicular to the plane of the wafer (and along the axis of the waveguide), a variable magnetic field is applied. In this configuration, a given incident $TE_{11}$ wave will cause two reflected waves. One is the ordinary reflected wave in the same polarization as the incident one. This is used to measure sheet resistance. The other reflected wave is caused by the Hall effect. Its polarization is perpendicular to the former wave and this can be separately detected with a properly configured probe.

A device (claim 1) for measurement of mobility and sheet charge density in conductive sheet materials includes a microwave source; a circular waveguide positioned to receive microwave power from the microwave source; a mount adapted to position a sheet material item at a measurement location to receive microwave power transmitted from the circular waveguide; a magnet positioned to induce a magnetic field at the measurement location; a first detector positioned to detect the power of the microwave power source; a second detector positioned to detect the power of the microwave power reflected from a sheet material item in the measurement location; and a third detector positioned to detect a Hall effect microwave power. A fourth detector may be provided to detect magnetic field strength at the measurement location. The mount may have a surface and a disc positioned in the mount, said disc having a planar surface recessed from said mount surface, said disc being rotatable about an axis substantially perpendicular to the plane of said disc planar surface, and said disc having a bore therein, said bore not being coaxial with said axis of rotation.

A method (claim 19) for measurement of mobility and sheet charge density in conductive sheet materials includes generating microwave power; transmitting only the $TE_{11}$ mode of the generated microwave power successively to a sheet material sample; during the step of transmission, applying a magnetic field of selected intensities; detecting microwave field strength at a forward position; detecting microwave field strength reflected from each of a conductive short and a sample; detecting Hall effect microwave field strength; and, based on the detected microwave field strengths, calculating values for mobility and sheet charge density.

An automatic handling system is disclosed for measurement of mobility and sheet charge density in conductive sheet materials. The system can comprise a microwave source, a waveguide positioned to receive microwave power from said microwave source, and an an end effector adapted to position a sheet material item at a measurement location to receive microwave power transmitted from said circular waveguide. The end effector can be movable between an adjustment position and a test position, wherein the adjustment position is a position at which the rotational position of the sheet material item is selectably adjustable, and the test position is the position at which at least one test can be performed on the sheet material item using the waveguide. The system can further comprise a magnet positioned to induce a magnetic field at the test location, a first detector to detect the power of the microwave power source, a second detector to detect the power of the microwave power reflected from a sheet material item in the measurement location, and a third detector to detect a Hall effect microwave power.

The automatic handling system may further comprising a second end-effector configured to engage the sheet material item, and a sheet resistance unit having first and second oppositely disposed coils for measuring the sheet resistance of the sheet material item, wherein the second end-effector is movably adjustable with respect to the sheet resistance unit to enable the unit to take a plurality of measurements on the sheet material item.

A mount for sheet material is disclosed, comprising an end effector for engaging an item of sheet material and moving it along a first axis, the end effector further configured to be rotated about the first axis using a first servo motor. A rotator-lifter is also included for engaging the item of sheet material and moving it along a second axis substantially perpendicular to said first axis, the rotator-lifter further configured to rotate about the second axis using a second servo motor, wherein the end effector and the rotator-lifter each comprises at least one vacuum element for engaging an item of sheet material. The mount can further comprise an adjustable base being movable using a third servo motor, the end effector being mounted on the adjustable base for movement with respect to the rotator-lifter.

Examples are shown in the figures.

Fig. 1 is a schematic diagram of an apparatus according to an example of the invention.

Fig. 2 is a schematic diagram of an apparatus according to an example of the invention.

Fig. 3 is a view of a portion of an apparatus according to an example of the invention.

Fig. 4 is a cross-section of the apparatus of Figure 3.

Fig. 5 is a view of the apparatus.

Figs. 5A, 5B, and 5C are views of a component of the apparatus.

Fig. 6 is a flowchart of software used according to the invention;

Fig. 7 is a perspective view of an automatic wafer handling system for use with the apparatus of Figs. 1-5C;

Fig. 8 is a perspective view of the system of Fig. 7, attached to the apparatus of Figs. 1-5C;

Fig. 9 is a detail view of the system of Fig. 7, illustrating various system components;

Fig. 10 is a detail view of an end effector of the system of Fig. 7, engaged with a sheet material item;

Fig. 11 is a detail view of the end effector of Fig. 10 in a rotated position;

Fig. 12 is a detail view of the end effector and sheet material item of Fig. 10 in a test position;

Fig. 13 is a detail view of the end effector and sheet material item of Fig. 10 in a post-testing position;

Fig. 14 is a perspective view of the automatic wafer handling system of Fig. 7, including a sheet resistance subsystem;

Fig. 15 is a detail view of the sheet resistance subsystem of Fig. 14;

Fig. 16 is a detail view of a sheet resistance module of the subsystem of Fig. 14;

Fig. 17 is a detail view of an end effector of the sheet resistance subsystem of Fig. 14 engaged with a sheet material item to be tested;

Fig. 18 is a detail view of the end effector and sheet material item of Fig. 17 configured in a test position within the sheet resistance module;

Fig. 19 is a detail view of the end effector and sheet material item of Fig. 14 in a post-testing position.

## DETAILED DESCRIPTION

The present invention includes an apparatus and method for measurement of sheet resistance and sheet charge density in semiconductive materials. The device includes a microwave source, that has an output coupled to a waveguide configuration in which a small amount of the incident wave is diverted, and the greater portion of the incident wave is transmitted along a main branch. The main branch is coupled to a circular waveguide. The circular waveguide transmits only the $TE_{11}$ (transverse electric 1, 1) mode of the microwave power. The circular waveguide receives power at an interface, and outputs power to a test region having a mount for supporting either a conductive test item, such as a short, or a wafer or other conductive sheet item to be tested. A magnet is provided to apply a magnetic field at the test region. At least four values are detected in the calculation of sheet resistance and sheet charge density in a method and apparatus of the invention. A detector is provided to detect the total microwave power output. A second detector is provided to detect the strength of a conventional reflected wave in the same polarization as the incident wave. A third detector is provided to detect a second reflected wave having a polarization opposite to that of the incident wave. There is preferably provided a Hall effect probe to detect this rotated reflected wave, which probe is electrically coupled to a directional coupler. The diverted portion of the incident wave, after passing through a variable attenuator and variable phase shifter, is also coupled to this Hall directional coupler, in order to eliminate by destructive interferences any spurious incident signal at said detector. The Hall directional coupler is then coupled to a detector. A fourth detector detects the magnetic field strength.

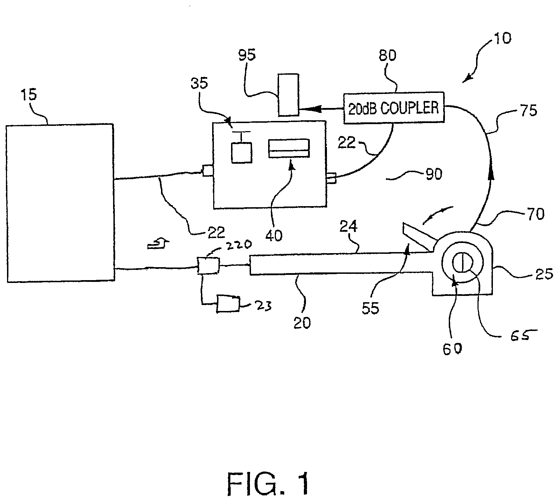

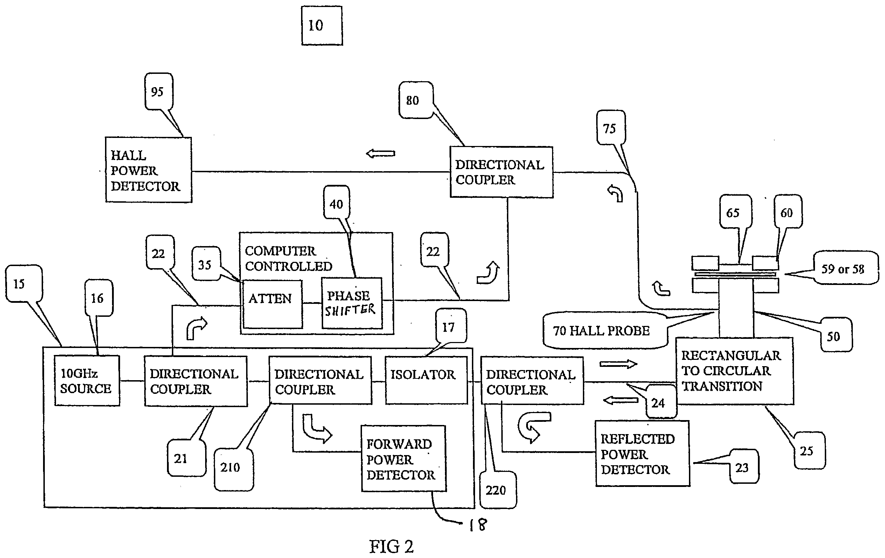

Figures 1 and 2 depict schematically the components of an apparatus 10 in accordance with the invention. Apparatus 10 includes microwave source module 15 which may provide microwaves having a frequency of about 10 GHz, although other frequencies may be employed. For example, higher frequencies may be employed to enable a smaller measurement area on the wafer or other item being tested. Source module 15 may include a Gunn diode, for example, and other sources may be employed. Source module 15 includes the microwave source 16, such as a Gunn diode, which is coupled to means for diverting a small portion of the forward power to a side branch, or attenuation and phase branch. The means for diverting a small portion of the forward power to a side branch may be coupler 21. Coupler 21 may be, for example, a cross guide coupler, and may be more specifically by way of example a 20dB cross guide coupler or a directional coupler. Directional coupler 21 is coupled to side branch 22, discussed below. The majority of the power output by source 16 is coupled through coupler 21 to a second directional coupler 210. Second directional coupler 210 provides a portion of the power to forward power detector 18. Second directional coupler 210 may be a 10dB coupler. Second directional coupler 210 outputs the majority of the power through a waveguide to isolator 17. Isolator 17 may be of conventional or other suitable design to prevent power from elsewhere in apparatus 10 from entering source 15. A second isolator may be used in series with isolator 17.

The diversion of a portion of the forward power to side branch 22 is used in properly balancing the Hall effect probe to zero in the absence of an applied magnetic field. The side branch 22 has a single computer controlled variable attenuator 35 and computer controlled variable phase shifter 40 in order to produce a very small signal of the proper phase that can be used to make an ultra-fine correlation in zeroing the Hall effect probe in the absence of a magnetic field. As the variable attenuator 35 and variable phase shifter 40 are preferably-computer controlled, adjustments are facilitated. It will be understood that, in principle, the variable attenuator and phase shifter could be manually adjustable.

The main output of coupler 21 will be referred to as main branch 24. Main branch 24 preferably has a waveguide for transmission of microwave power to transition 25. Main branch 24 may include conventional rectangular waveguide 20. As shown in Fig. 2, reflected power detector 23 is shown in main branch 24. Reflected power detector 23 detects microwave power being transmitted from transition 25 toward source 15. Reflected power detector 23 detects power reflected from test items back into main branch 24. Directional coupler 220, in main branch 24 and coupled to source 15 and transition 25, directs reflected power from main branch 24 to reflected power detector 23.

As noted above, a circular waveguide is provided positioned to receive microwave power from source 15. Specifically, circular waveguide 50 is coupled through coupler 21 and main branch 24 to source 15. Conventional rectangular waveguide 20 is coupled via a matched transition 25 into circular waveguide 50. Circular waveguide 50 is a cylindrical waveguide with a circular cross-section. Circular waveguide 50 transmits only the $TE_{11}$ mode of the power. Circular waveguide interface 25 is coupled to circular waveguide 50, shown, for example, in Figure 2. The coupling of the circular waveguide 50 to conventional waveguide 20 must be calibrated carefully to minimize reflection and loss of signal strength. The calibration procedure is set forth below. Circular waveguide 50 is mounted on interface 25 perpendicular to the long axis of conventional waveguide 20. The calibration may be effected by adjustment of the position of circular waveguide 25 along its long axis relative to interface 25. In one embodiment, circular waveguide 50 is mounted on the interface 25. A circular waveguide adjustment 55 is provided in the form of a handle that rotates circular waveguide 50, so that the rotational position of circular waveguide 50 may be adjusted.

A mount 60 is provided to hold a sample of sheet material at a measurement location where microwave power transmitted from the circular waveguide 50 is received. The sample may be a wafer or other semiconductive test material 59. A moving short 65 is provided on the opposite side of the wafer or other material from the opening of circular waveguide 50. The moving short 65 will be placed ¼ wavelength from the wafer or other material. Moving short 65 may be in the form of a polished metal plug. Moving short 65 is mounted in mount 60, which may be in the form of a vacuum chuck.. Mount 60 is adapted to hold a wafer or other material in sheet form at an end of circular waveguide 50 opposite to interface 25. Moving short 65 is provided inside of mount 60 and is capable of being positioned precisely. Mount 60 can move relative to circular waveguide 50 in order to adjust the gap between waveguide 50 and moving short 65.

A detector, forward power detector 18, is positioned in source module 15 to detect the forward power. As noted above, a directional coupler 220 is positioned in main branch 24 so as to direct reflected microwave power to detector 23. The reflected power detected by detector 23 has the same polarization as the forward microwave power. Hall probe 70 is inserted in circular waveguide 50 positioned to detect Hall effect microwave power reflected from material positioned in the vacuum chuck. Hall probe 70 may be located at a variety of positions within circular waveguide 50. The Hall effect power has polarization perpendicular to the polarization of the incident wave. As discussed below, the calibration and tuning process provides that only the Hall effect power is detected by Hall detector 95.

Hall probe 70 is coupled through coaxial line 75 to an input of directional coupler 80. Directional coupler 80 may be a 20 dB directional coupler. The output of branch 22, after passing through the attenuator module and variable phase shifter, is connected to an input of directional coupler 80. The output of directional coupler 80 is coupled to Hall detector 95. The calibration process, as described below, provides that the Hall detector 95 detects only power having a polarization perpendicular to that of the forward power. This power detected by Hall detector 95 is thus Hall effect power reflected from a sample.

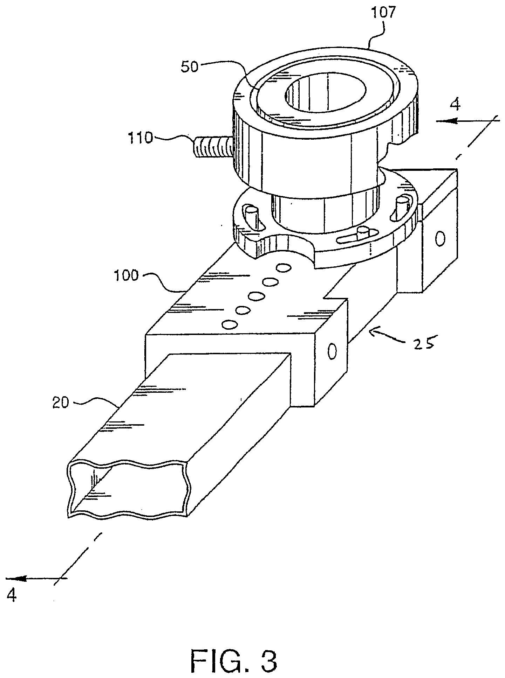

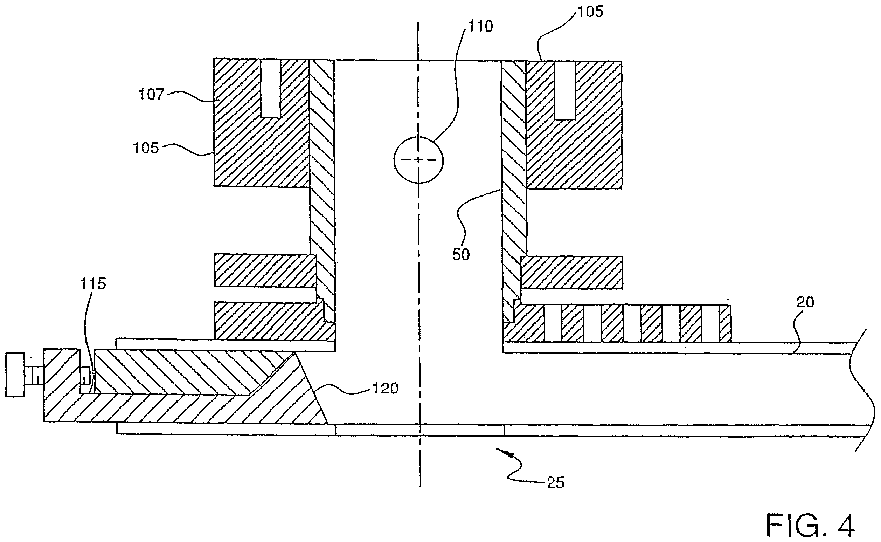

Details of an exemplary embodiment of the transition, circular waveguide, and mount will now be described. Figure 3 is an isometric view, with partial cutaway, of interface 25. Figure 4 is a sectional view along line 4-4 of Fig. 3. Interface 25 has a primary rectangular chamber 100 coupled at one end thereof to conventional waveguide 20. On an upper side of rectangular chamber 100 an aperture is provided to which circular waveguide 50 is attached. Interior to interface 25, opposite to conventional waveguide 20, there is provided a beam stop 115 completely filling an opening, and having a tapered face, preferably at an angle of 30 degrees to vertical, at 120. It will be appreciated that interface 25 may be modified by those of skill in the art by alternative designs to minimize reflection and loss at the interface between circular waveguide 50 and conventional waveguide 20. In Figs. 3-4, it may be seen that circular waveguide 50 includes a probe flange 107 at an upper end thereof which has therein an opening for a probe at 110. A Hall probe may be inserted at 110.

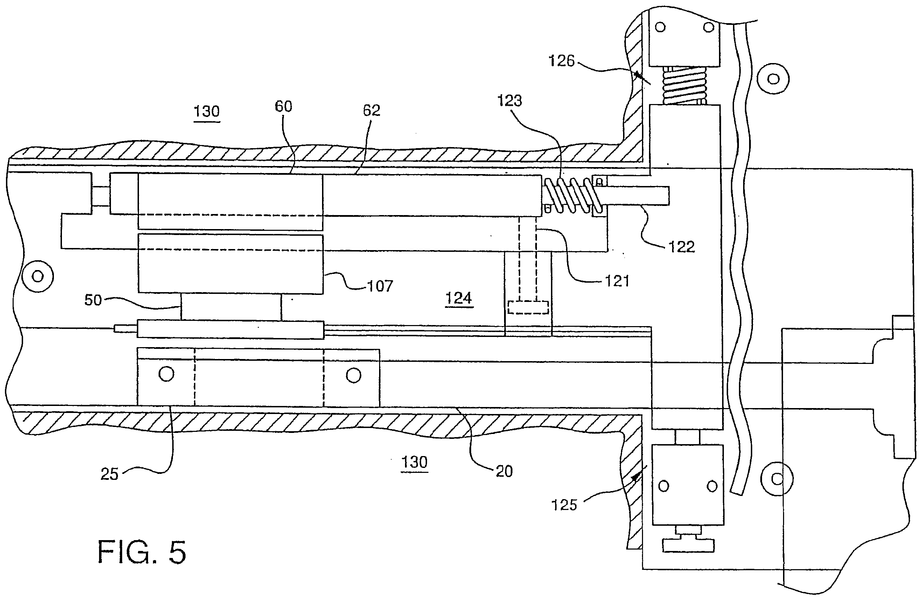

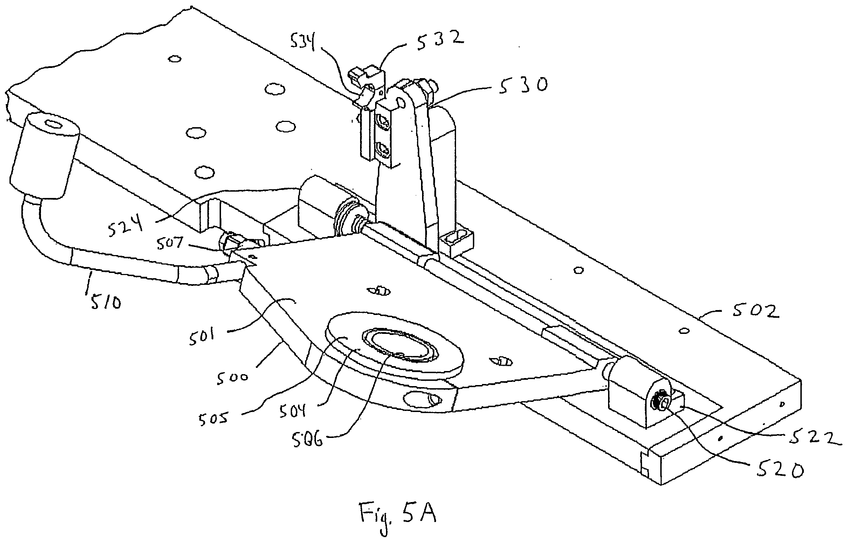

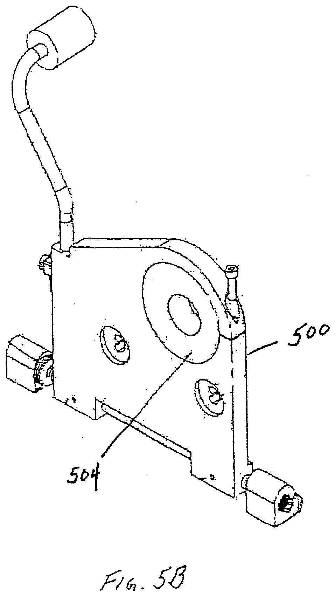

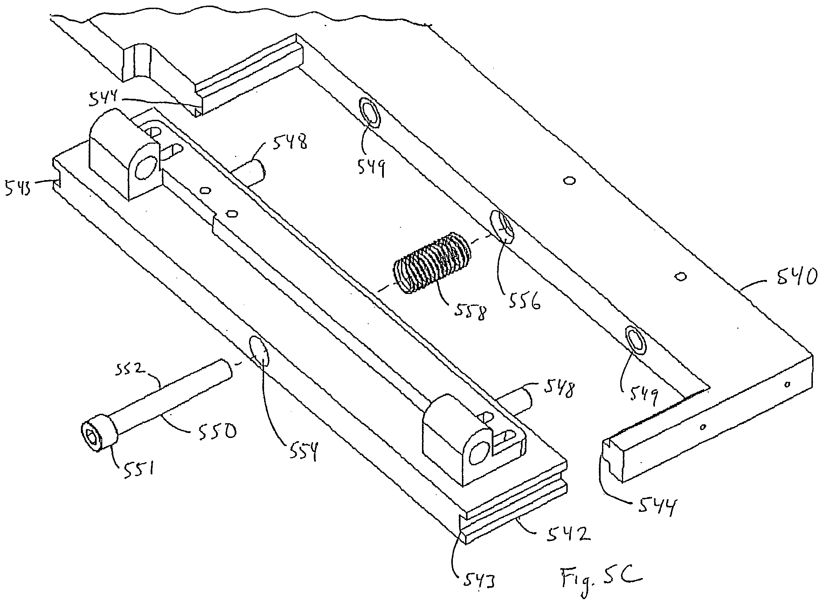

Figure 5 is a side view depicting an exemplary arrangement including circular waveguide 50, holder or mount 60, and related exemplary hardware. Holder or mount 60 serves to position a sheet material item to receive microwave power from circular waveguide 50. Conventional waveguide 20 is shown coupled to interface 25. Interface 25 is shown coupled to circular waveguide 50. Probe flange 107, located at an end of circular waveguide 50 opposite the coupling to interface 25, is opposite holder 60, in the form of a vacuum chuck. Vacuum chuck 60 is supported by an arm, which is chuck holder 62. Chuck holder 62 is supported by adjustable screws 121, 122, thereby permitting adjustment of the position of vacuum chuck 60 in two axes. Screws 121, 122 are supported on bridge 124, which is itself adjustably mounted as shown at 125, 126. Spring 123 may be provided on screw 122 to reduce the transfer of any vibrations in bridge 124. It will be understood that other configurations may be employed for the positioning of holder 60 relative to circular waveguide 50.

Referring to Fig. 5A, an example of a holder is shown. In this example, a positioning fixture 500 is rotatably mounted on a base 502. Fixture 500 has therein a rotatable disc 504 with a cylindrical through bore positioned off center. Disc 504 can be described as an eccentric slug in fixture 500. More particularly, fixture 500 has a surface 501, which is generally planar, and disc 504 has a surface 505, which may be planar and raised from mount surface 501. Mount surface 501 and disc surface 505 may be parallel. Disc 504 is rotatable about an axis substantially perpendicular to the plane of mount surface 501. Bore 506, which may define a right circular cylinder, is not coaxial with the axis of rotation of disc 504. Rotation of disc 504 adjusts the position of the bore 506 relative to base 502, effectively permitting adjustment of bore 506 in the vertical direction. Bore 506 defines the portion of a wafer or other material fixed on fixture 500 exposed to the output of circular waveguide 50. Rotation of disc 504 permits vertical adjustment, which combined with horizontal adjustment using screw 520 as described below, provides for alignment with waveguide 50. Fixture 500 may be a vacuum fixture or vacuum chuck, having an interior chamber at low pressure and small bores therein to fix material on the fixture. Connections can be made to a pump through a port at 507. Handle 510 may be employed to move fixture 500 in and out of position.

Fixture 500 is rotatably mounted on base 502 by a set screw 520 which presses on a shaft extends through bores in raised mounts 522, 524, which are rigidly fixed to base 502. A thrust bearing and a compression spring at mount 524 hold fixture 500 in place. Screw 520 engages a threaded bore in mount 522, so that rotation of screw 520 moves the shaft, thereby permitting fine adjustment of the position of the positioning fixture in a horizontal axis. In operation, the position of the fixture is adjusted by adjustment of both screw 520 and turning disc 504 until the fixture is properly positioned. The fixture 500 may then be locked in place. Arm 530, also rigidly fixed to base 502, prevents rotation of fixture 500 beyond a predefined point. An approximately semi-cylindrical concave surface defined on finger 532 of arm 530 receives a cylindrical knob 507 on an edge of fixture 500. Referring to Fig. 5B, fixture 500 is shown in a closed or operational position from the opposite side.

Referring to Fig. 5C, base 502 is divided into stationary portion 540 and movable portion 542, on which fixture 500 is mounted. Movable portion 542 is movable relative to stationary portion 540 perpendicular to the axis of screw 520, thereby permitting adjustment of the position of fixture 500 so as to adjust the gap between fixture 500 (and hence any sample mounted thereon) and the opening of circular waveguide 50. In this embodiment, mating grooves 543 and rails 544, and mating pins 548 and bores 549, permit adjustment of movable portion 542 in only one direction. A threaded pin 550 has a head 551 which engages a surface of movable portion 542; body 552 of pin 550 traverses a smooth bore 554 in movable portion 542 and engages a threaded bore 556 in stationary portion 540. A constant separation is further maintained by providing a device to urge movable portion 542 to the maximum separation permitted by the position of pin 550. An example is shown as coil spring 558, which engages surfaces of movable portion 542 and stationary portion 540. Any suitable substitute for coil spring 558 may be employed.

Referring again to Fig. 5, Figure 5 also shows generally the position of magnet 130 which provides the necessary magnetic field. The magnetic field is applied perpendicular to the plane of the wafer or other sample and along the long axis of circular waveguide 50. The design of one or more suitable magnets to provide the desired magnetic field strength is within the level of ordinary skill in the art. As noted below, in one example, the magnetic field strength at the wafer or other item positioned in the holder is desirably up to 10kG or higher, if necessary.

The calibration and operation of the apparatus will now be discussed. This entire process may be carried out at room temperature. Room temperature is understood to include a range of temperatures at which humans may comfortably work. Room temperature excludes low temperatures, such as the boiling temperature of liquid nitrogen at atmospheric pressure. Power meters are preferably connected to the Hall detector cable, an input or forward power location, and a reflected power location. A gauss meter is provided to measure the intensity of the magnetic field. Commercial meters with RS232 or IEEE 488 bus communications are preferably used. A short 58, such as a gold plated copper coated PC board, is placed on the vacuum chuck and positioned. The computer controlled attenuation adjustment 35 is increased to a maximum. The position of the circular waveguide 50 is adjusted to obtain minimum power at Hall detector 95. While monitoring the Hall detector power meter, the computer controlled attenuation adjustment 35 is then adjusted, preferably automatically using the computer software, to bring detected power to a minimum. The computer controlled phase adjustment 40 is then adjusted, preferably automatically using the computer software, to obtain a minimum on the Hall detected power. The attenuation adjustment and phase adjustment are automatically adjusted using the computer software, to obtain a minimum here. The Hall detector power, forward detector power, and reflected detector power are recorded. The short is removed and replaced with the sample to be checked. The short tuning adjustment 65 of the vacuum chuck position is adjusted to obtain a minimum reflected power. The circular waveguide adjustment 55, attenuation adjustment 35 and phase adjustment 40 are all adjusted for a minimum on the Hall detector. The three powers are then recorded for 0 magnetic field, and then at successive incrementally greater magnetic field strengths. The field strength ranges from 0-9 kG as a minimum. Preferably, the magnetic field is automatically varied using computer software that controls the magnet power supply to obtain the desired magnetic field. In principle, with further developments, significantly lower magnetic field strengths could be used in accordance with the method. The number of magnetic field values and the spacing between magnetic field values can be optimized to maximize analysis accuracy.

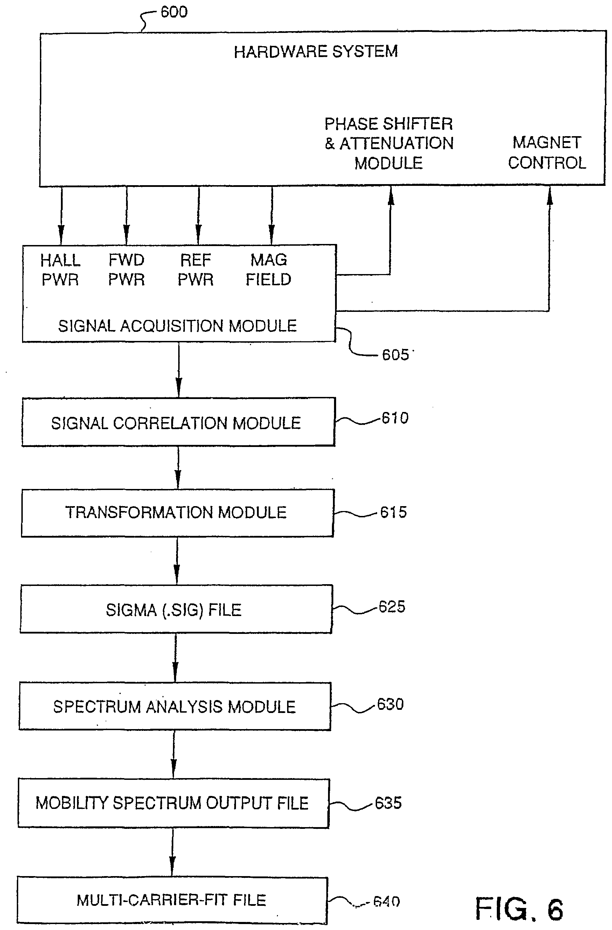

The data are then interpreted to obtain mobility, sheet charge density and sheet resistance readings. Referring to Figure 6, an overview of the software is provided. The software may be written for a personal computer using an Intel Pentium or compatible chip as a processor, and the DOS or Windows operating systems. The hardware system described above is indicated generally by block 600. The first module, 605, is a signal acquisition and control module. This module receives signals from the detectors in the apparatus described above and controls the variable phase shifter and attenuator module as well as the magnet. The received signals are: Hall Power detection; Forward Power detection of Cu Short and Wafer; Reflected Power detection of Cu Short and Wafer; and Magnetic Field Strength detection. Those signals are passed through power amplifiers and/or superhet receivers to analog to digital converters and module 605 obtains values from the digital output. Once these signals are acquired the corresponding voltage input values are passed on to the Signal Correlation Module 610 for further processing.

Signal correlation module 610 receives inputs from the signal acquisition module 605 as raw input voltages. These voltages are input into algorithms to obtain values in correct engineering units. This step is a straightforward correlation.

The output of the signal correlation module 610 is received by the transformation module 615. The transformation module converts the output to Sigma Output file structure 625 which is then read by the Mobility Spectral Analysis Module 630. The Sigma Output file is composed of 14 lines of general test information, typically including the sample name, date, and similar information, followed by a line containing the sample thickness, followed by a line for each magnetic field at which Hall data was collected. Each of these data lines contain tab-separated entries for the magnetic field, Sigma_XX, SD_XX, Sigma_XY, and SD_XY, where SD_XX and SD_XY are the standard deviations for the Sigma_XX and Sigma_XY values, respectively. All entries are in MKSA units, i.e. thickness in meters, magnetic field in Tesla, and conductivities in Siemens/meter. This file is used as input for the Mobility Spectral Analysis Module in order to obtain the final mobility values and sheet charge densities. This module is composed of two separate program dynamic link libraries, which perform a variety of mathematical calculations in order to analyze magnetic field-dependent Hall data. These modules read input data from the Sigma Output file and generate a mobility spectrum output file 635 which includes a mobility spectrum whose peaks indicate the presence of discrete carrier types and a Multi-Carrier-Fit file 640 which includes the most likely mobility and sheet charge density values for those carrier types.

The only way to find solutions that are more precise or quantitative than the mobility spectrum peaks is to restrict the range of possible solutions by making assumptions about the carriers in the specimen. For example, the Multi-Carrier fitting technique makes the explicit assumption that there are a fixed number of carriers - each with a discrete mobility.

The calculations carried out by the software involve the following principles. When the microwave short at the back of the cavity behind the wafer is adjusted to the proper distance, the relationship between an amplitude reflection coefficient $\Gamma$, the sheet resistance of the wafer R, and the impedance Z of the circular waveguide for the $TE_{11}$ mode is:

$$\Gamma = (R - Z)/(R + Z)$$

For a circular waveguide of radius 1.045 cm, the impedance has been found to be 697.5 Ohm/square, which enables accurate measurement of a thin cap.

The microwave electric field at the wafer must be determined. The electric field amplitude in various axes, $E_x$, for example, are represented as $E_x = (1 + \Gamma) (P_{incident}/A)^{1/2}$, and $E_y = (P_{Hall}/A)^{1/2}$. In the x direction, the amplitude is the sum of the incident and reflected wave amplitudes or the amplitude of the transmitted (standing) wave. For the y direction, the only propagating microwave signal is the Hall wave, which is generated at the wafer and detected in the reflected direction. The value A is a constant, which may be determined by integration across the circular cross section of the waveguide mode. The conductivity, $\sigma_{xx}$, or $\sigma_{xy}$, depending on the axis, can be represented, using these values, as $\sigma_{xx} = (1/Z) (1 - \Gamma^2 - F^2)/((1 + \Gamma)^2 + F^2)$, and as $\sigma_{xy} = (F/(2Z(1 + \Gamma)) ((1 + \Gamma) (3 - \Gamma) - F^2)/((1 + \Gamma)^2 + F^2)$, where F = $E^-_{y1}/E^+_{x1}$. There is also a constant coefficient used to multiply the theoretical values of F since the currents that are locally perpendicular to the excited $TE_{11}$ mode do not couple exactly to the orthogonal $TE_{11}$ mode. The constant can be obtained by integration and has a value between 0 and 1. The previous analysis assumes that additional modes that are generated near the wafer are negligible. In some cases that is not valid. For those cases, a multi-mode analysis has been developed and can be used to determine Sigma_XX and Sigma_XY from the reflected microwave powers.

In order to obtain the mobility, the results of the calculations above are employed together with the detected magnetic field intensity B. For one carrier species in a single conductive layer, the carrier mobility is given by $\mu = (\sigma_{xy}/B)/\sigma_{xx}$.

The multi-carrier fitting procedure works as follows: First, the program determines the best fit for a single carrier using the Simplex method to minimize the least-squares deviation.between the fitted and measured Hall data ($\sigma_{xx}$ and $\sigma_{xy}$). The uncertainty in each of the measured data is used to weight the terms in the least-squares sum and thereby obtain the most-likely solution. The uncertainties in the derived mobility and carrier density are estimated from the components of the Hessian matrix at the minimum (at the solution).

Next, the program determines the best fit using two carriers. The starting values for the Simplex procedure are obtained by displacing the previously-determined single carrier to slightly higher and lower mobilities. The Simplex procedure is identical to the procedure for a single carrier, except that there are now two mobilities to vary. The uncertainties in the derived parameters are again determined as in the description for a single carrier. The program also uses the statistical F-test to estimate the significance of the second carrier, i.e., it estimates whether addition of the second carrier improved the fit by enough to conclude that a second carrier probably exists. This is a very useful feature since it permits the user to estimate the number of statistically significant carriers that are present in the sample. The procedure continues, adding one carrier at a time and estimating the significance of the added carriers, until the number of carriers exceeds half the number of magnetic fields, at which point the procedure is terminated.

A summary of test results comparing the foregoing techniques to known destructive techniques, namely the contacted single magnetic field DC Hall technique, are set forth below:

TABLE

**PHEMT TEST RESULT SUMMARY**
**A - CONTACTED SINGLE MAGNETIC FIELD DC HALL**
**B - NONCONTACT MULTIPLE MAGNETIC FIELD RF**
**THIN CAP PHEMT SAMPLES**

| | WAFER # 1 Mobility cm2/V-s | Sheet Charge X E12 carriers/cm2 |
|---|---|---|
| **A** | 5391 | 2.67 |

(continued)

| THIN CAP PHEMT SAMPLES | | |
| --- | --- | --- |
| WAFER # 1 | Mobility cm2/V-s | Sheet Charge X E12 carriers/cm2 |
| B | 4721 | 2.848 |
| B | 4780 | 2.837 |
| B | 4753 | 2.859 |
| | 4751.3 | 2.848 |
| STD | 24.115 | 0.00898146 |
| STD% | 0.508% | 0.315% |
| WAFER # 2 | Mobility cm2/V-s | Sheet Charge X E12 carriers/cm2 |
| A | 5391 | 2.67 |
| B | 4721 | 2.831 |
| B | 4780 | 2.852 |
| B | 4753 | 2.827 |
| | 4751.3 | 2.83666667 |
| STD | 24.115 | 0.01096459 |
| STD% | 0.508% | 0.387% |
| THICK CAP PHEMT SAMPLE | | |
| | Mobility cm2/V-s | Sheet Charge X E12 carriers/cm2 |
| A | 7096 | 2.44 |
| B | 7783 | 1.46 |

Analysis software may be provided for use in non destructive, noncontact measurements of full semiconductor wafers or flat panel display materials for use by operators with minimal training. Experienced researchers are provided with the capability to perform in depth studies by varying readily accessible test parameters. Such test parameters include the magnet field strength, and attenuation of the microwave signal along the branch. The software also may provide graphic display including plots of the mobility spectra with conductivity and concentration as a function of mobility.

Plots of sheet charge density and mobility as a function of magnetic field may be displayed using a single carrier solution to the data of each field. The single carrier solution is used as a general check of the analysis; a sample with a single carrier should exhibit the same sheet charge density and mobility irrespective of the magnetic field. Conversely, a sample with more than one detectable carrier should exhibit variations as a function of the magnetic field.

All results may be displayed as sheet concentration numbers in the text window of the software. A calculation of the volumetric concentration of electrical carriers could be launched by checking the window of the result-screen of the software. If this operation is selected, the one-carrier solution is extracted by the multi-carrier technique and displayed in a separate window together with the entry fields for layer thickness and carrier type. This information is then used to calculate the depletion widths from the top surface and epi-substrate interfaces, so that the true thickness of the conductive layer can be obtained. Alternatively, the user could enter a thickness and have the program present the volumetric results for the one- or many-carrier fit based on the entered thickness.

It should be noted that single field analysis techniques may be used as an alternative to multi-carrier analysis described above.

It will be appreciated that variations in mobility and sheet charge density across a layer may be obtained by conducting a test on a sample, then moving the sample in the mount in the plane perpendicular to the central axis of circular waveguide 50, and then repeating the test. This process may be repeated in order to obtain a map of mobility and sheet charge density.

**Automatic Mapping Subsystem**

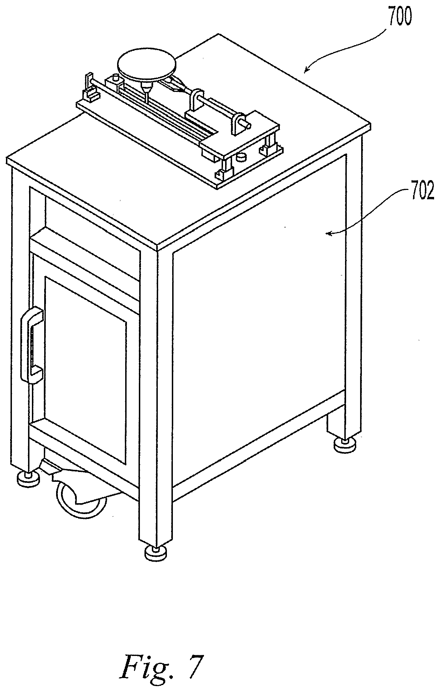

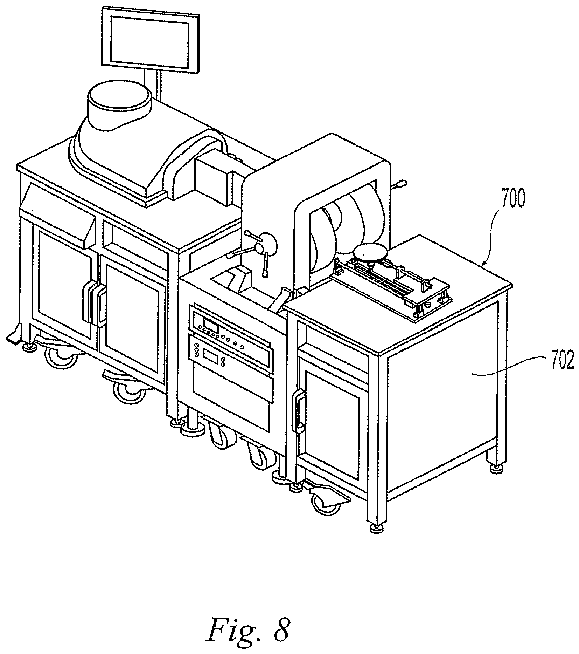

**Fig. 7** illustrates a subsystem for use with the apparatus described in relation to **Figs. 1-5C,** and which can be used to automate the wafer or flat panel mobility mapping process. This automatic mobility mapping subsystem (hereinafter referred to as "the automapper") **700**, can be mounted inside and/or on top of a system cabinet **702. Fig. 8** shows the automapper cabinet **702** positioned and attached to the mobility mapping system of **Figs. 1-5C.** As will be appreciated, the automapper **700** can be provided as an upgrade to current mobility mapping systems, or as an integrated option for new units to be built.

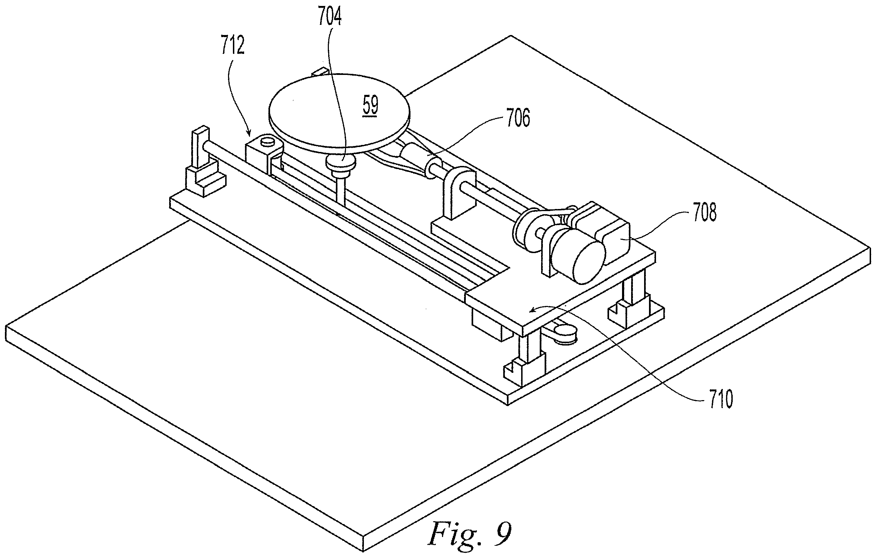

**Fig. 9** shows the main components of the automapper **700**, including a rotator/lifter **704**, an end effector **706**, a servo motor **708** for rotating the end-effector about its longitudinal axis, an x-axis table **710**, and a servo motor **712** for adjusting the x-axis table. Not shown are the servo motors that will operate the rotator/lifter **704**. The rotator/lifter **704** will lift and rotate the wafer **59** to be tested. The end effector **706** will hold the wafer **59** under test, and the servo motor **708** associated with the end effector **706** will rotate the end effector (and wafer) to the desired vertical orientation so that the wafer can be inserted into the test area.

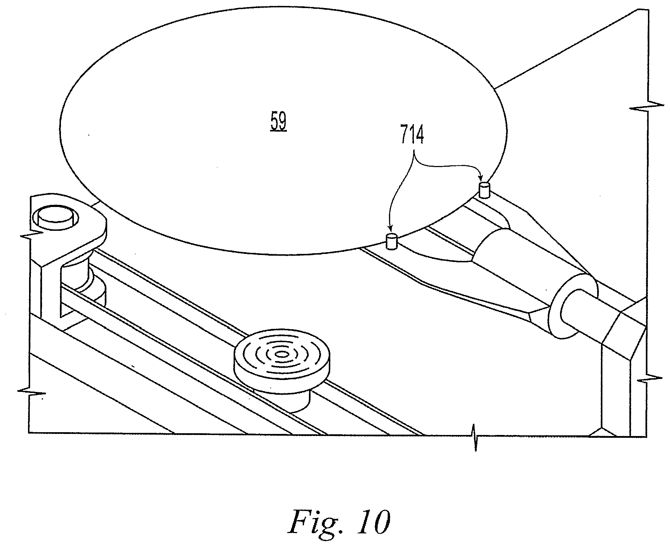

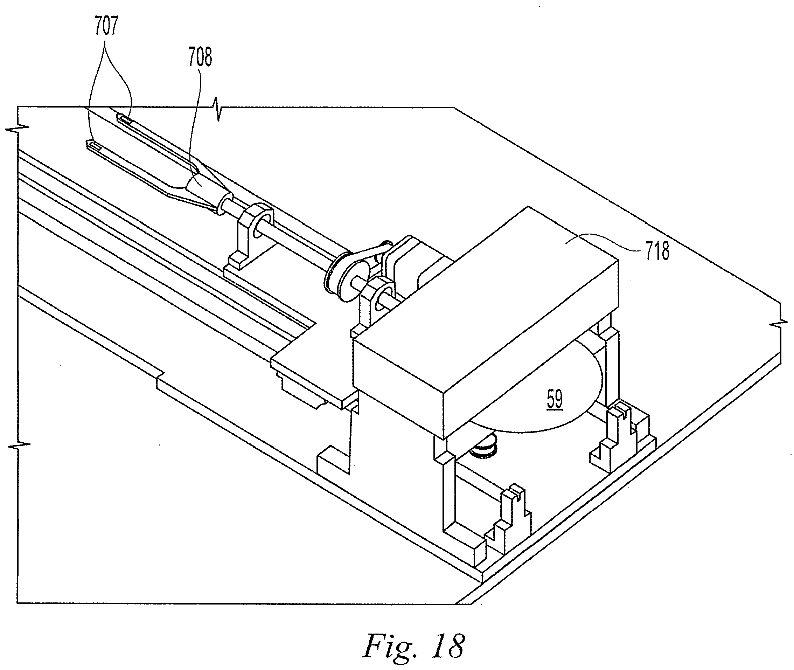

**Fig. 10** is a detail view of the wafer **59** mounted on the end effector **706** using a pair of alignment pins **714**. An operator would load a wafer **59** to be tested onto the end effector **706** using the alignment pins **714** positioned to receive the particular size wafer to be tested. A plurality of different pin locations corresponding to different wafer sizes would be provided to allow the user to easily establish the wafer on the end effector at the proper position for testing. Once the wafer **59** is positioned on the end effector **706**, the operator will initiate a computer-controlled automated testing program, which will automatically turn on vacuum elements **707 (Fig. 18)**) located on the end effector **706** to hold the wafer **56** in place during testing.

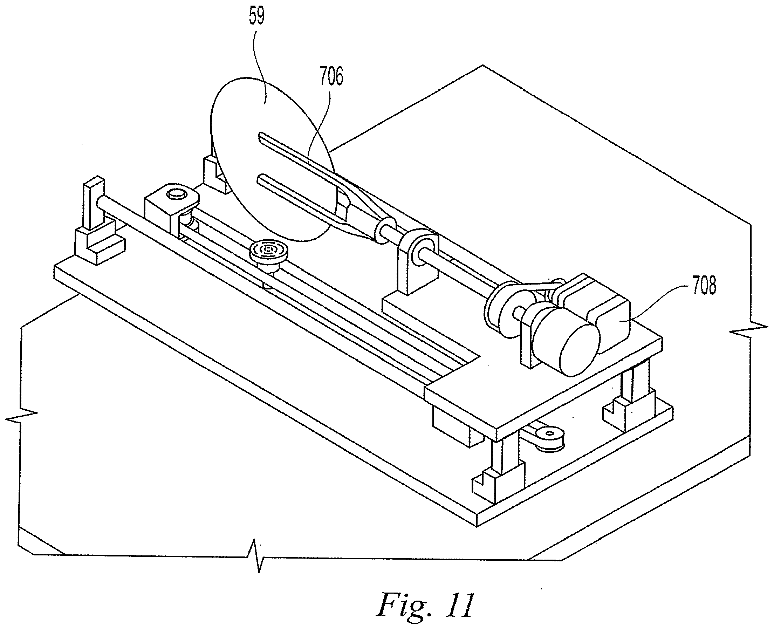

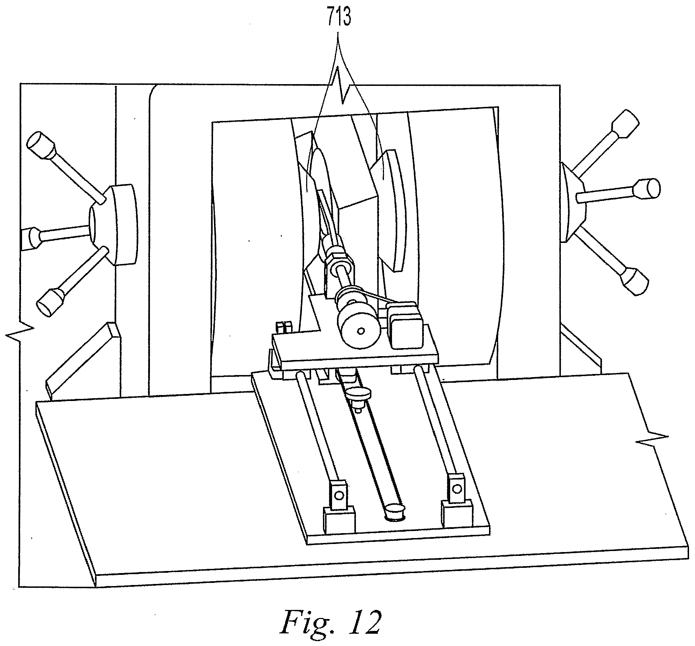

**Fig. 11** shows how the servo motor **708** is used to rotate the end effector 706 and the wafer **59** 90-degrees to assume a desired vertical position for testing. Once this vertical position is achieved, the servo motor **712** associated with the x-table **710** will operate to move the end effector **706** and wafer **59** along the x-axis into a test position (**Fig. 12**), between the poles of the magnet **713** of the mobility mapping system of **Figs. 1-5C.** This is the test position. The computerized testing program will control performance of the desired mobility testing and the collection of data points needed to complete the mobility map, in the manner previously described in relation to **Figs. 1-6.**

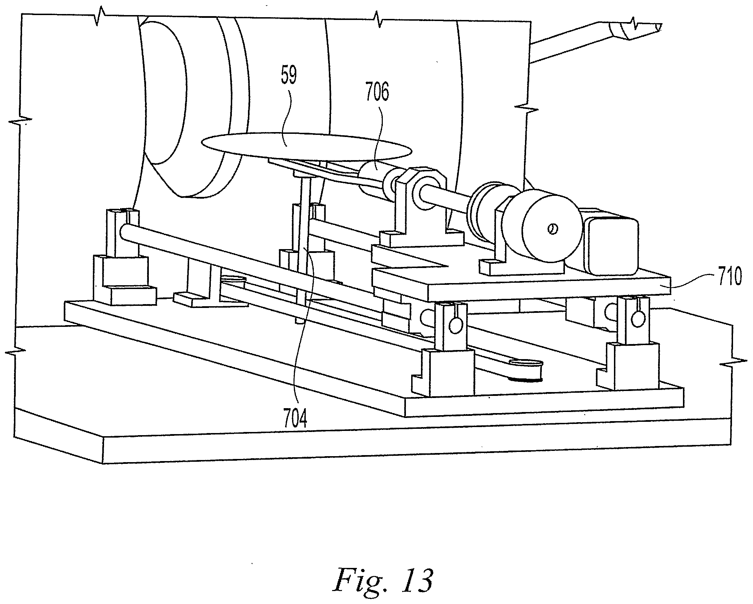

After the series of data points is collected, the wafer is withdrawn from the magnet **130** and is rotated back to its horizontal position, using the servo motor **708** associated with the end effector **706**, as shown in **Fig. 13.** At this point, the rotator/lifter **704** assembly will raise up to engage the wafer **59**. The rotator/lifter will engage the wafer using one or more vacuum elements (not shown) and will rotate the wafer to change the wafer's theta angle (the angle at which a particular set of data scans will occur), preparing the wafer for collection of another series of test data points in the manner already described. Thus, once the appropriate theta angle has been achieved, the rotator/lifter **704** will lower the wafer back down onto the end effector **708**, the vacuum elements of the end effector will be actuated, and the end effector and wafer will again be rotated 90-degrees. The end effector and wafer will again be moved between the poles of the magnet **130** and the desired series of data points collected for the new theta angle position. This test process of will be repeated until the desired number of data points are collected for the wafer under test. In one embodiment, a complete mobility map of the wafer will be obtained using this technique.

As previously noted, all of the above steps can be automated and controlled using an appropriate computer program.


**Sheet Resistance Subsystem**

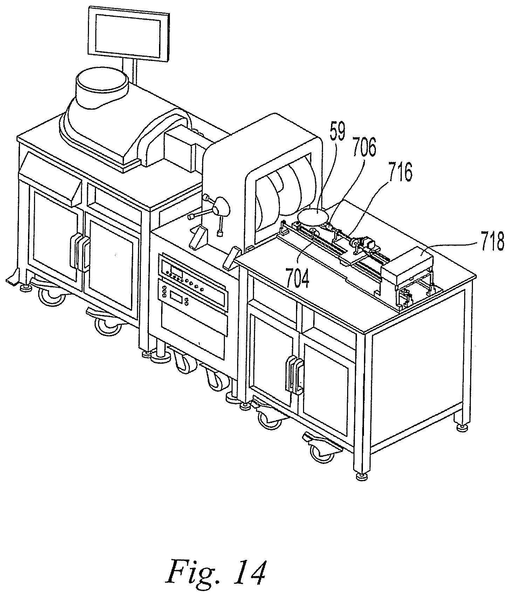

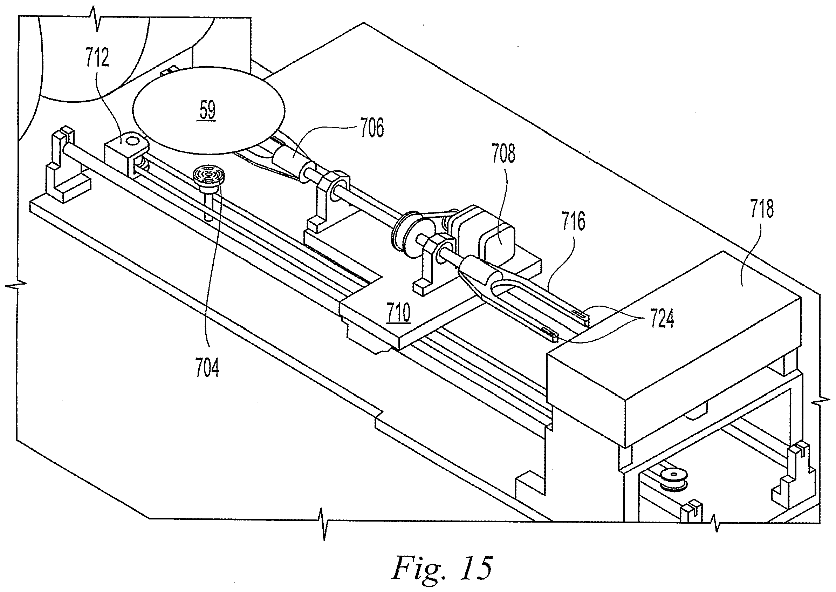

**Fig. 14** shows the automapper subsystem of **Figs. 7-13**, attached to the mobility measuring system of **Figs. 1-5C**, in combination with an additional subsystem feature for automatically measuring the sheet resistance of a wafer. **Fig. 15** illustrates the main components of the combined automapper and sheet resistance module subsystems, including a pair of end effectors **706, 716**, a servo motor **708** for controlling rotation of both end effectors about their longitudinal axis, and a sheet resistance module **718**. A sliding table **710** is provided for moving the end effectors along an x-axis plane in relation to the mobility measuring system and the sheet resistance module **718**. The end effectors **706, 716** and servo motor **708** will be mounted on the sliding table **710**, and the sheet resistance module **718** will remain stationary. Not shown is the servo motor that will operate the Rotator/Lifter **704.**

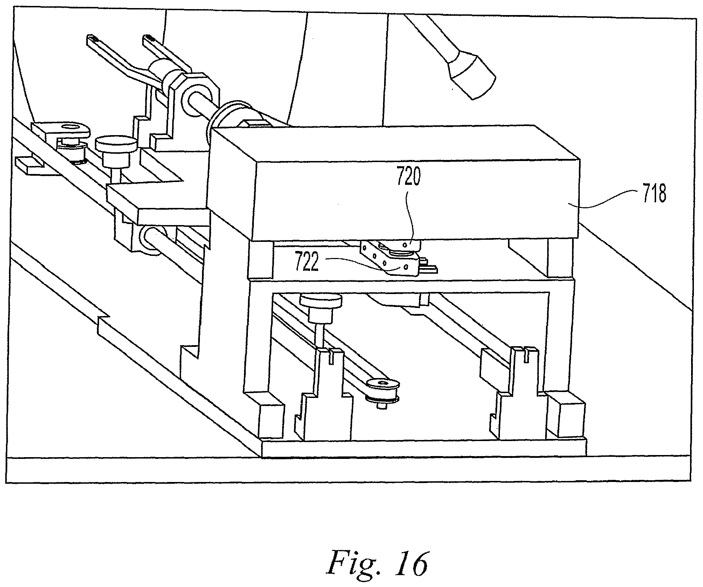

The sheet resistance module **718** can have a pair of opposing coils **720, 722 (Fig. 16)** used to measure the resistance of the wafer **59** or other appropriate sheet material (e.g. flat panel) placed therebetween. The principles of operation of the sheet resistance module **718**, as well as details of the design, are disclosed in U.S. Patent Nos. 6,711,948 B2, issued 3/30/2004, and 6,443,002 B2, issued 9/3/2002, assigned to Lehighton Electronics.

The automapper of this embodiment will be configured and will operate in the same manner as described above in relation to **Figs. 7-13.**

**Fig. 16** shows the sheet resistance module **718** in greater detail, illustrating the position of the upper and lower measurement coils **720, 722,** between which a wafer or sheet **59** will be inserted for testing using the end effector **716** and associated components.

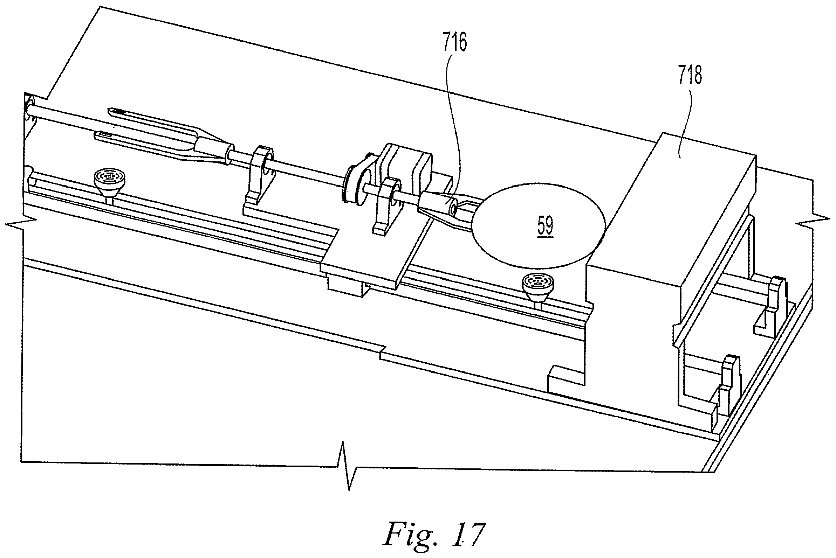

**Fig. 17** shows an exemplary wafer **59** positioned on the end effector **716** associated with the sheet resistance module **718** prior to being inserted into the module for testing. **Fig. 18** shows the wafer **59** positioned within the sheet resistance module **718** for testing. To achieve this positioning, the system operator will position the wafer **59** on the end effector **716** using positioning pins (not shown) similar to those used for end effector **708.** The operator will then initiate a computer program configured to control movement of the end effector **716** along the x-direction with respect to the sheet resistance module **718**. The program will automatically turn on the vacuum elements **724 (Fig. 15)** of the end effector **716** to hold the wafer **59** in place. The program will then cause the end effector **716** to slide along the x-axis (by operation of servo motor **712**) to place the wafer within the sheet resistance module **718**. Thus, the wafer will be moved between the coils **720, 722** to a plurality of testing locations along the x-axis to take the desired series of sheet resistance measurements.

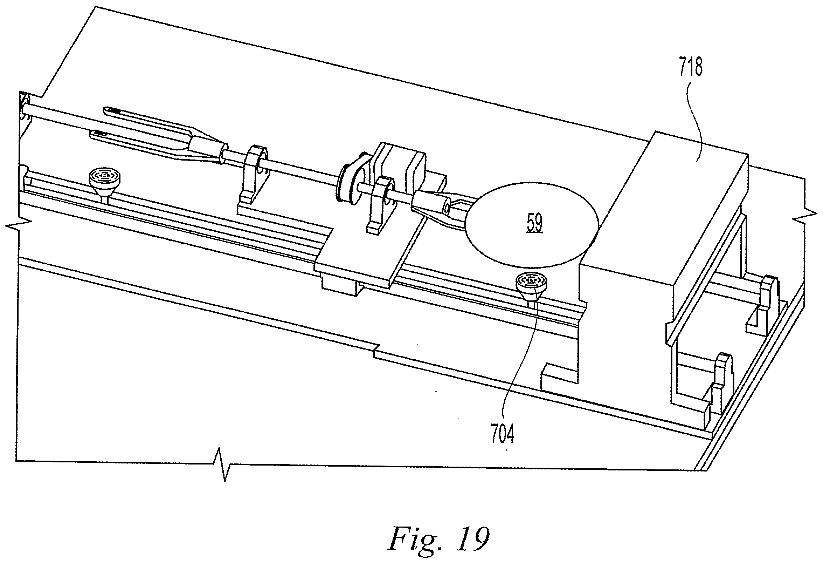

**Fig. 19** shows the wafer **59** withdrawn from the sheet resistance module **718** after taking a first series of test measurements. The rotator/lifter **704** is positioned to engage the wafer, to raise it up off the end effector and to rotate it to change the theta angle. Once the desired new theta angle is achieved, the rotator/lifter **704** sets the wafer back down onto the end effector **716,** the vacuum elements **724** will be reactivated to lock the wafer to the end effector, and the x-table servo motor **712** will be used to re-insert the wafer **59** into the sheet resistance module **718** in the manner previously described to collect another series of data points associated with the new theta angle. This process will be re-performed until the sheet resistance mapping is complete. It will be appreciated that all of these steps can be automated and controlled using an appropriate computer program.

While the invention has been described above with respect to particular embodiments, modifications and substitutions within the scope of the invention as defined by the claims will be apparent to those of skill in the art.

## Claims

**1.** Device for measurement of mobility and sheet charge density in conductive sheet materials, comprising:

a microwave source (15);
a first waveguide positioned to receive microwave power from said microwave source;
an adjustable mount (60) adapted to adjustably position a sheet material item at a plurality of measurement locations to receive microwave power transmitted from said first waveguide;
a magnet (130) positioned to induce a magnetic field at the test location;
a first detector (18) to detect the power of the microwave power source;
a second detector (23) to detect the power of the microwave power reflected from a sheet material item in a measurement location from the plurality of measurement locations;
a third detector to detect a Hall effect microwave power,

wherein said adjustable mount further comprises a first end effector adapted to position the sheet material item at the plurality of measurement locations to receive microwave power transmitted from said first waveguide, said first end effector being movable between an adjustment position and a test position,
wherein said adjustment position is a position at which the rotational position of the sheet material item is selectably adjustable, and said test position is a position at which at least one test can be performed on the sheet material item using the first waveguide, wherein the device further comprises a rotator-lifter for engaging said sheet material item and moving it along a second axis substantially perpendicular to a longitudinal axis of said first end effector, the rotator-lifter further configured to rotate about the second axis using a motor unit,
wherein said first end effector and said rotator-lifter each comprise at least one vacuum element for engaging said sheet material item,
wherein the rotator lifter is operable when said sheet material item is in said adjustment position, the rotator lifter lifting said sheet material item from said first end effector for rotation when said sheet material is in said adjustment position,
wherein said first end effector engages said sheet material item at said test position while said at least one test is performed on the sheet material item using the first waveguide.

**2.** Device of claim 1, further comprising a probe positioned in said first waveguide, said probe being coupled to said third detector, said first waveguide being a circular waveguide.

**3.** Device of claim 2, further comprising a directional coupler positioned to receive microwave power from said source, said directional coupler being coupled to a side branch and a main branch, said main branch being coupled to said first waveguide, and said side branch being coupled to said third detector.

**4.** Device of claim 3, wherein said side branch is coupled through a variable attenuator (35) and a variable phase shifter (40) to said third detector.

**5.** Device of claim 1, further comprising calculating means for receiving data from said detectors and for calculating mobility and sheet charge density based on said data.

**6.** Device of claim 5, further comprising a power amplifier for receiving a signal from at least one of said detectors and for providing an output signal to said calculating means.

**7.** Device of claim 5, further comprising a superheterodyne receiver for receiving a signal from at least one of said detectors and for providing an output signal to said calculating means.

**8.** Device of claim 1, further comprising a second waveguide intermediate said microwave source and said first waveguide, wherein said first waveguide is adjustably positioned relative to said second waveguide.

**9.** Device of claim 8, wherein said second detector is positioned to detect reflected microwave field strength in said second waveguide, said device further comprising a fourth detector to detect magnetic field strength at the measurement location.

**10.** Device of claim 1, further comprising a short, made of conductive material, said short being adjustably mounted with respect to said device so that said measurement location is intermediate said short and an end of said first waveguide.

**11.** Device of claim 1, wherein said adjustable mount further comprises:

a body having a first planar surface;
a disc positioned in said mount, said disc being rotatable about an axis substantially perpendicular to a plane of said first planar surface, said disc further having a bore therein that is not coaxial with said axis of rotation; wherein said disc is configured to contact said sheet material item to adjustably position said sheet material item so that at least one of said plurality of measurement locations is located adjacent said first waveguide to receive microwave power from said first waveguide.

**12.** Device of claim 11, wherein said adjustable mount comprises a vacuum chuck (62).

**13.** Device of claim 11, further comprising a base, said adjustable mount being rotatably positioned on a base.

**14.** Device of claim 11, wherein said adjustable mount is positioned on an adjustable portion of said base, whereby a separation between said adjustable mount and a waveguide of said testing apparatus may be adjusted.

**15.** Device of claim 1, wherein said first end effector has a longitudinal axis, said first end effector being rotatable about said longitudinal axis, said end effector further being translatable with respect to said device along said longitudinal axis.

**16.** Device of claim 1, further comprising end effector motor unit, said end effector motor unit being associated with said first end effector for rotating said first end effector about said longitudinal axis, wherein said first end effector is in a rotated position when said sheet material item is at said test position for said at least one test to be performed on the sheet material item using the first waveguide.

**17.** Device of claim 1, further comprising:

a second end-effector configured to engage said sheet material item; and
a sheet resistance unit having first and second oppositely disposed coils for measuring a sheet resistance property of said sheet material item, wherein said second end-effector is movably adjustable with respect to said sheet resistance unit to enable the unit to measure said sheet resistance property at a plurality of locations on said sheet material item.

**18.** Device of claim 1, further comprising an adjustable base that is movable with respect to said device using a fourth motor unit, the end effector being mounted on the adjustable base for movement with respect to the rotator-lifter.

**19.** Method of operating for measuring mobility and sheet charge density in a conductive sheet material item (59), the method comprising the steps of:

supplying a microwave (15) power;
providing a first waveguide, positioned to receive the microwave power;
adapting an adjustable mount (60) to adjustably position the sheet material item (59) in a plurality of measurement locations to receive microwave power transmitted from said first waveguide;

wherein

- a magnet (130) is positioned to induce a magnetic field at a test location;
- a first detector (18) detects the power of the microwave power;
- a second detector (23) detects power of reflected microwave power, reflected from the sheet material item in a measurement location from a plurality of measurement locations;
- a third detector detects a Hall effect microwave power for a sheet material item (59), such as a wafer

wherein said adjustable mount further comprises a first end effector adapted to position the sheet material item at the plurality of measurement locations to receive microwave power transmitted from said first waveguide, said first end effector being movable between an adjustment position and a test position,

wherein said adjustment position is a position at which the rotational position of the sheet material item is selectably adjustable, and said test position is a position at which at least one test can be performed on the sheet material item using the first waveguide, wherein the device further comprises a rotator-lifter for engaging said sheet material item and moving it along a second axis substantially perpendicular to a longitudinal axis of said first end effector, the rotator-lifter further configured to rotate about the second axis using a motor unit,

wherein said first end effector and said rotator-lifter each comprise at least one vacuum element for engaging said sheet material item,

wherein the rotator lifter is operable when said sheet material item is in said adjustment position, the rotator lifter lifting said sheet material item from said first end effector for rotation when said sheet material is in said adjustment position,

wherein said first end effector engages said sheet material item at said test position while said at least one test is performed on the sheet material item using the first waveguide.

**20.** Method of claim 19, the microwave power having a frequency of at least 10 GHz.

**Patentansprüche**

**1.** Vorrichtung zum Messen von Mobilität und Flächenladungsdichte in leitfähigen Plattenmaterialien; umfassend:

eine Mikrowellenquelle (15);
einen ersten Wellenleiter, positioniert zum Empfangen einer Mikrowellenleistung von der Mikrowellenquelle;
eine einstellbare Halterung (60), die ausgestaltet ist einen Plattenmaterialgegenstand an einer Vielzahl von Messorten einstellbar zu positionieren, um eine von der dem ersten Wellenleiter übertragene Mikrowellenleistung zu empfangen;
einen Magneten (130), positioniert zum Induzieren eines magnetischen Felds an dem Test-Ort;
einen ersten Detektor (18) zum Detektieren der Leistung der Mikrowellenleistungsquelle;
einen zweiten Detektor (23) zum Detektieren der Leistung der von einem Plattenmaterialgegenstand in einer Messposition von der Vielzahl von Messorten reflektierten Mikrowellenleistung;
einen dritten Detektor zum Detektieren einer Hall-Effekt-Mikrowellenleistung,

wobei die einstellbare Halterung einen ersten Endeffektor umfasst, der ausgebildet ist zum Positionieren des Plattenmaterialgegenstands an der Vielzahl von Messpositionen zum Empfangen von Mikrowellenleistung, übertragen von dem ersten Wellenleiter, wobei der erste Endeffektor zwischen einer Einstellposition und einer Test-Position bewegbar ist,

wobei die Einstellposition eine Position ist, an der die Rotationsposition des Plattenmaterialgegenstands selektierbar einstellbar ist, und die Test-Position eine Position ist, an der zumindest ein Test an dem Plattenmaterialgegenstand unter Verwendung des ersten Wellenleiters durchgeführt werden kann,

wobei die Vorrichtung einen Rotator-Heber (rotator-lifter) zum Erfassen des Plattenmaterialgegenstands und zum Bewegen des Plattenmaterialgegenstands entlang einer zweiten Achse, die im Wesentlichen senkrecht zu einer Längsachse des ersten Endeffektors ist, umfasst, und der Rotator-Heber ausgestaltet ist, um die zweite Achse unter Verwendung einer Motoreinheit zu rotieren,

wobei der erste Endeffektor und der Rotator-Heber jeweils mindestens ein Vakuumelement zum Erfassen des Plattenmaterialgegenstands umfasst,

wobei der Rotator-Heber operabel ist, wenn der Plattenmaterialgegenstand in der Einstellposition ist, und der Rotator-Heber den Plattenmaterialgegenstand von dem ersten Endeffektor für eine Rotation hebt, wenn der Plattenmaterialgegenstand in der Einstellposition ist,

wobei der erste Endeffektor den Plattenmaterialgegenstand an der Test-Position erfasst, während zumindest ein Test an dem Plattenmaterialgegenstand unter Verwendung des ersten Wellenleiters durchgeführt wird.

2.  Vorrichtung nach Anspruch 1, mit einer Sonde, die in dem ersten Wellenleiter positioniert ist, wobei die Sonde mit dem dritten Detektor gekoppelt ist und der erste Wellenleiter ein runder Wellenleiter ist.

3.  Vorrichtung nach Anspruch 2, mit einem Richtkoppler, positioniert zum Empfangen von Mikrowellenleistung von der Quelle, wobei der Richtkoppler mit einem Seitenzweig und einem Hauptzweig gekoppelt ist, wobei der Hauptzweig mit dem ersten Wellenleiter gekoppelt ist und der Seitenzweig mit dem dritten Detektor gekoppelt ist.

4.  Vorrichtung nach Anspruch 3, wobei der Seitenzweig durch einen variablen Abschwächer (35) und einen variablen Phasenschieber (40) mit dem dritten Detektor gekoppelt ist.

5.  Vorrichtung nach Anspruch 1, mit einem Berechnungsmittel zum Empfangen von Daten von den Detektoren und zum Berechnen von Mobilität und Flächenladungsdichte auf Grundlage der Daten.

6.  Vorrichtung nach Anspruch 5, mit einem Leistungsverstärker zum Empfangen eines Signals von zumindest einem der Detektoren und zum Bereitstellen eines Ausgangssignals an das Berechnungsmittel.

7.  Vorrichtung nach Anspruch 5 mit einem Überlagerungsempfänger zum Empfangen eines Signals von zumindest einem der Detektoren und zum Bereitstellen eines Ausgangssignals an das Berechnungsmittel.

8.  Vorrichtung nach Anspruch 1, mit einem zweiten Wellenleiter zwischen der Mikrowellenquelle und dem ersten Wellenleiter, wobei der erste Wellenleiter relativ zu dem zweiten Wellenleiter einstellbar positioniert ist.

9.  Vorrichtung nach Anspruch 8, wobei der zweite Detektor zum Detektieren von reflektierter Mikrowellenfeldstärke in dem zweiten Wellenleiter positioniert ist, wobei die Vorrichtung einen vierten Detektor zum Detektieren von Magnetfeldstärke an dem Messort umfasst.

10.  Vorrichtung nach Anspruch 1, mit einem Kurzschluss (short), bestehend aus einem leitfähigen Material, wobei der Kurzschluss relativ zu der Vorrichtung einstellbar angebracht, so dass der Messort zwischen dem Kurzschluss und einem Ende des ersten Wellenleiters liegt.

11.  Vorrichtung nach Anspruch 1, wobei die einstellbare Halterung umfasst:

einen Körper mit einer ersten planaren Oberfläche;

eine Scheibe, die in der Halterung angeordnet ist, wobei die Scheibe um eine Achse, die im Wesentlichen senkrecht zu einer Ebene der ersten planaren Oberfläche ist,

rotationsfähig ist, wobei die Scheibe eine Bohrung aufweist, die nicht koaxial mit der Rotationsachse ist;

wobei die Scheibe ausgestaltet ist, den Plattenmaterialgegenstand zu kontaktieren zum einstellbaren Positionieren des Plattenmaterialgegenstands, so dass zumindest eine der Vielzahl der Messorte benachbart zu dem ersten Wellenleiter liegt, um Mikrowellenleistung von dem ersten Wellenleiter zu empfangen.

12.  Vorrichtung nach Anspruch 11, wobei die einstellbare Halterung eine Unterdruckspannvorrichtung (62) umfasst.

13.  Vorrichtung nach Anspruch 11, mit einem Sockel, wobei die einstellbare Halterung rotationsfähig auf einem Sockel positioniert ist.

14.  Vorrichtung nach Anspruch 11, wobei die einstellbare Halterung auf einem einstellbaren Abschnitt des Sockels positioniert ist, wodurch eine Trennung zwischen der einstellbaren Halterung und einem Wellenleiter des Test-Apparats eingestellt werden kann.

15. Vorrichtung nach Anspruch 1, wobei der erste Endeffektor eine Längsachse aufweist und der erste Endeffektor um die Längsachse rotationsfähig ist, wobei der Endeffektor relativ zu der Vorrichtung entlang der Längsachse translationsfähig ist.

16. Vorrichtung nach Anspruch 1, mit einer Endeffektor-Motoreinheit, wobei die Endeffektor-Motoreinheit mit dem ersten Endeffektor zum Rotieren des ersten Endeffektors um die Längsachse gekoppelt ist, wobei der erste Endeffektor in einer rotierten Position ist, wenn der Plattenmaterialgegenstand an der Test-Position ist zum Durchführen des zumindest einen Tests an dem Plattenmaterialgegenstand unter Verwendung des ersten Wellenleiters.

17. Vorrichtung nach Anspruch 1, mit:

einem zweiten Endeffektor, der ausgestaltet ist den Plattenmaterialgegenstand zu erfassen; und
einer Schichtwiderstandseinheit mit einer ersten und zweiten Spule, die gegenüberliegend angeordnet sind, zum Messen einer Schichtwiderstandseigenschaft des Plattenmaterialgegenstands, wobei der zweite Endeffektor bewegbar einstellbar relativ zu der Schichtwiderstandseinheit ist, um eine Messung der Schichtwiderstandseigenschaft an einer Vielzahl von Orten auf dem Plattenmaterialgegenstand zu ermöglichen.

18. Vorrichtung nach Anspruch 1, mit einem einstellbaren Sockel, der relativ zu der Vorrichtung unter Verwendung einer vierten Motoreinheit bewegbar ist, wobei der Endeffektor auf dem einstellbaren Sockel zum Bewegen relativ zu dem Rotator-Heber befestigt ist.

19. Betriebsverfahren zum Messen von Mobilität und Flächenladungsdichte in einem leitfähigen Plattenmaterialgegenstand (59), wobei das Verfahren die Schritte umfasst:

Bereitstellen einer Mikrowellenleistung (15);
Bereitstellen eines ersten Wellenleiters, positioniert zum Empfangen einer Mikrowellenleistung;
Anpassen einer einstellbaren Halterung (60), die ausgestaltet ist den Plattenmaterialgegenstand in einer Vielzahl von Messorten einstellbar zu positionieren, um eine von der dem ersten Wellenleiter übertragene Mikrowellenleistung zu empfangen;

wobei

- ein Magnet (130) zum Induzieren eines magnetischen Felds an einem Test-Ort positioniert ist;
- ein erster Detektor (18) die Leistung der Mikrowellenleistungsquelle detektiert;
- ein zweiter Detektor (23) die Leistung der von dem Plattenmaterialgegenstand in einer Messposition von der Vielzahl von Messorten reflektierten Mikrowellenleistung detektiert;
- ein dritter Detektor eine Hall-Effekt-Mikrowellenleistung für einen Plattenmaterialgegenstand (59), beispielsweise ein Wafer, detektiert

wobei die einstellbare Halterung einen ersten Endeffektor umfasst, der ausgebildet ist zum Positionieren des Plattenmaterialgegenstands an der Vielzahl von Messpositionen zum Empfangen von Mikrowellenleistung, die von dem ersten Wellenleiter übertragen wird, wobei der erste Endeffektor zwischen einer Einstellposition und einer Test-Position bewegbar ist,
wobei die Einstellposition eine Position ist, an der die Rotationsposition des Plattenmaterialgegenstands selektierbar einstellbar ist, und die Test-Position eine Position ist, an der zumindest ein Test an dem Plattenmaterialgegenstand unter Verwendung des ersten Wellenleiters durchgeführt werden kann,
wobei die Vorrichtung einen Rotator-Heber zum Erfassen des Plattenmaterialgegenstands und zum Bewegen des Plattenmaterialgegenstands entlang einer zweiten Achse, die im Wesentlichen senkrecht zu einer Längsachse des ersten Endeffektors ist, umfasst, und der Rotator-Heber ausgestaltet ist, um die zweite Achse unter Verwendung einer Motoreinheit zu rotieren,
wobei der erste Endeffektor und der Rotator-Heber jeweils mindestens ein Vakuumelement zum Erfassen des Plattenmaterialgegenstands umfasst,
wobei der Rotator-Heber operabel ist, wenn der Plattenmaterialgegenstand in der Einstellposition ist, und der Rotator-Heber den Plattenmaterialgegenstand von dem ersten Endeffektor für eine Rotation hebt, wenn der Plattenmaterialgegenstand in der Einstellposition ist,
wobei der erste Endeffektor den Plattenmaterialgegenstand an der Test-Position erfasst, während zumindest ein Test an dem Plattenmaterialgegenstand unter Verwendung des ersten Wellenleiters durchgeführt wird.

**20.** Verfahren nach Anspruch 19, wobei die Mikrowellenleistung eine Frequenz von mindestens 10 GHz aufweist.

**Revendications**

**1.** Dispositif pour mesurer la mobilité et la densité de charge de feuille dans des matériaux de feuille conducteurs, comprenant:

une source micro-onde (15);

un premier guide d'onde positionné de manière à recevoir une puissance micro-onde en provenance de ladite source micro-onde;

une monture réglable (60) apte à positionner de façon réglable un élément de feuille à une pluralité d'emplacements de mesure de manière à recevoir une puissance micro-onde transmise par ledit premier guide d'onde;

un aimant (130) positionné de manière à induire un champ magnétique à l'emplacement d'essai;

un premier détecteur (18) pour détecter la puissance de la source de puissance micro-onde;

un deuxième détecteur (23) pour détecter la puissance de la puissance micro-onde réfléchie par un élément de feuille dans un emplacement de mesure parmi une pluralité d'emplacements de mesure;

un troisième détecteur pour détecter la puissance micro-onde de l'effet Hall,

dans lequel ladite monture réglable comprend en outre un premier effecteur terminal apte à positionner l'élément de feuille à la pluralité d'emplacements de mesure de manière à recevoir la puissance micro-onde transmise par ledit premier guide d'onde, ledit premier effecteur terminal étant déplaçable entre une position de réglage et une position d'essai,

dans lequel ladite position de réglage est une position dans laquelle la position de rotation de l'élément de feuille peut être réglée de façon sélective, et ladite position d'essai est une position dans laquelle au moins un essai peut être effectué sur l'élément de feuille en utilisant le premier guide d'onde,

dans lequel le dispositif comprend en outre un rotateur-élévateur pour engager ledit élément de feuille et déplacer celui-ci le long d'un second axe sensiblement perpendiculaire à un axe longitudinal dudit premier effecteur terminal, le rotateur-élévateur étant en outre configuré de manière à tourner autour du second axe en utilisant une unité de moteur, dans lequel ledit premier effecteur terminal et ledit rotateur-élévateur comprennent chacun au moins un élément à vide pour engager ledit élément de feuille,

dans lequel le rotateur-élévateur est actionnable lorsque ledit élément de feuille se trouve dans ladite position de réglage, le rotateur-élévateur soulevant ledit élément de feuille à partir dudit premier effecteur terminal pour effectuer une rotation lorsque ledit élément de feuille se trouve dans ladite position de réglage,

dans lequel ledit premier effecteur terminal engage ledit élément de feuille à ladite position d'essai pendant que ledit au moins un essai est effectué sur l'élément de feuille en utilisant le premier guide d'onde.

**2.** Dispositif selon la revendication 1, comprenant en outre une sonde positionnée dans ledit premier guide d'onde, ladite sonde étant couplée audit troisième détecteur, ledit premier guide d'onde étant un guide d'onde circulaire.

**3.** Dispositif selon la revendication 2, comprenant en outre un coupleur directionnel positionné de manière à recevoir une puissance micro-onde en provenance de ladite source, ledit coupleur directionnel étant couplé à une branche latérale et à une branche principale, ladite branche principale étant couplée audit premier guide d'onde, et ladite branche latérale étant couplée audit troisième détecteur.

**4.** Dispositif selon la revendication 3, dans lequel ladite branche latérale est couplée par l'intermédiaire d'un atténuateur variable (35) et d'un déphaseur variable (40) audit troisième détecteur.

**5.** Dispositif selon la revendication 1, comprenant en outre des moyens de calcul pour recevoir des données en provenance desdits détecteurs et pour calculer la mobilité et la densité de charge de feuille sur la base desdites données.

**6.** Dispositif selon la revendication 5, comprenant en outre un amplificateur de puissance pour recevoir un signal en provenance d'au moins un desdits détecteurs et pour envoyer un signal de sortie auxdits moyens de calcul.

**7.** Dispositif selon la revendication 5, comprenant en outre un récepteur superhétérodyne pour recevoir un signal en provenance d'au moins un desdits détecteurs et pour envoyer un signal de sortie auxdits moyens de calcul.

8.  Dispositif selon la revendication 1, comprenant en outre un second guide d'onde entre ladite source micro-onde et ledit premier guide d'onde, dans lequel ledit premier guide d'onde est positionné de façon réglable par rapport audit second guide d'onde.

9.  Dispositif selon la revendication 8, dans lequel ledit deuxième détecteur est positionné de manière à détecter une intensité de champ de micro-onde réfléchi dans ledit second guide d'onde, ledit dispositif comprenant en outre un quatrième détecteur pour détecter l'intensité de champ magnétique à l'emplacement de mesure.

10. Dispositif selon la revendication 1, comprenant en outre un court-circuit, constitué d'un matériau conducteur, ledit court-circuit étant monté de façon réglable par rapport audit dispositif de telle sorte que ledit emplacement de mesure soit situé entre ledit court-circuit et une extrémité dudit premier guide d'onde.

11. Dispositif selon la revendication 1, dans lequel ladite monture réglable comprend en outre:

    un corps présentant une première surface plane;
    un disque positionné dans ladite monture, ledit disque étant rotatif autour d'un axe sensiblement perpendiculaire à un plan de ladite première surface plane, ledit disque présentant en outre un alésage dans celui-ci qui n'est pas coaxial audit axe de rotation;
    dans lequel ledit disque est configuré de manière à entrer en contact avec ledit élément de feuille afin de positionner de façon réglable ledit élément de feuille de telle sorte qu'au moins un de ladite pluralité d'emplacements de mesure soit situé à proximité dudit premier guide d'onde de manière à recevoir une puissance micro-onde en provenance dudit premier guide d'onde.

12. Dispositif selon la revendication 11, dans lequel ladite monture réglable comprend un mandrin à vide (62).

13. Dispositif selon la revendication 11, comprenant en outre une base, ladite monture réglable étant positionnée de façon rotative sur une base.

14. Dispositif selon la revendication 11, dans lequel ladite monture réglable est positionnée sur une partie réglable de ladite base, moyennant quoi une séparation entre ladite monture réglable et un guide d'onde dudit appareil d'essai peut être réglée.

15. Dispositif selon la revendication 1, dans lequel ledit premier effecteur terminal présente un axe longitudinal, ledit premier effecteur terminal étant rotatif autour dudit axe longitudinal, ledit effecteur terminal pouvant en outre être déplacé par rapport audit dispositif le long dudit axe longitudinal.

16. Dispositif selon la revendication 1, comprenant en outre une unité de moteur d'effecteur terminal, ladite unité de moteur d'effecteur terminal étant associée audit premier effecteur terminal afin de faire tourner ledit premier effecteur terminal autour dudit axe longitudinal, dans lequel ledit premier effecteur terminal se trouve dans une position de rotation lorsque ledit élément de feuille se trouve dans ladite position d'essai afin que ledit au moins un essai soit effectué sur l'élément de feuille en utilisant le premier guide d'onde.

17. Dispositif selon la revendication 1, comprenant en outre:

    un second effecteur terminal configuré de manière à engager ledit élément de feuille; et
    une unité de résistance de feuille présentant des première et seconde bobines disposées en opposition pour mesurer une propriété de résistance de feuille dudit élément de feuille, dans lequel ledit second effecteur terminal peut être réglé de façon mobile par rapport à ladite unité de résistance de feuille dans le but de permettre à l'unité de mesurer ladite propriété de résistance de feuille en une pluralité d'emplacements sur ledit élément de feuille.

18. Dispositif selon la revendication 1, comprenant en outre une base ajustable qui est déplaçable par rapport audit dispositif en utilisant une quatrième unité de moteur, l'effecteur terminal étant monté sur la base réglable de manière à se déplacer par rapport au rotateur-élévateur.

19. Procédé de fonctionnement pour mesurer la mobilité et la densité de charge de feuille dans un élément de feuille conducteur (59), le procédé comprenant les étapes suivantes:

générer une puissance micro-onde (15);

prévoir un premier guide d'onde positionné de manière à recevoir la puissance micro-onde;

adapter une monture réglable (60) afin de positionner de façon réglable l'élément de feuille (59) dans une pluralité d'emplacements de mesure afin de recevoir la puissance micro-onde transmise par ledit premier guide d'onde;

dans lequel:

- un aimant (130) est positionné de manière à induire un champ magnétique à un emplacement d'essai;
- un premier détecteur (18) détecte la puissance de la puissance micro-onde;
- un deuxième détecteur (23) détecte la puissance d'une puissance micro-onde réfléchie, réfléchie par l'élément de feuille dans un emplacement de mesure parmi une pluralité d'emplacements de mesure;
- un troisième détecteur détecte une puissance micro-onde d'effet Hall pour un élément de feuille (59, tel qu'un wafer,

dans lequel ladite monture réglable comprend en outre un premier effecteur terminal apte à positionner l'élément de feuille à la pluralité d'emplacements de mesure de manière à recevoir une puissance micro-onde transmise par ledit premier guide d'onde, ledit premier effecteur terminal étant déplaçable entre une position de réglage et une position d'essai,

dans lequel ladite position de réglage est une position dans laquelle la position de rotation de l'élément de feuille peut être réglée de façon sélective, et ladite position d'essai est une position dans laquelle au moins un essai peut être effectué sur l'élément de feuille en utilisant le premier guide d'onde,

dans lequel le dispositif comprend en outre un rotateur-élévateur pour engager ledit élément de feuille et pour déplacer celui-ci le long d'un second axe sensiblement perpendiculaire à un axe longitudinal dudit effecteur terminal, le rotateur-élévateur étant en outre configuré de manière à tourner autour du second axe en utilisant une unité de moteur,

dans lequel ledit premier effecteur terminal et ledit rotateur-élévateur comprennent chacun au moins un élément à vide pour engager ledit élément de feuille,

dans lequel le rotateur-élévateur est actionnable lorsque ledit élément de feuille se trouve dans ladite position de réglage, le rotateur-élévateur soulevant ledit élément de feuille à partir dudit premier effecteur terminal pour effectuer une rotation lorsque ledit élément de feuille se trouve dans ladite position de réglage,

dans lequel ledit premier effecteur terminal engage ledit élément de feuille à ladite position d'essai pendant que ledit au moins un essai est effectué sur l'élément de feuille en utilisant le premier guide d'onde.

**20.** Procédé selon la revendication 19, dans lequel la puissance micro-onde présente une fréquence d'au moins 10 GHz.

FIG. 1

FIG 2

FIG. 3

FIG. 4

FIG. 5

EP 1 779 124 B1

Fig. 5A

FIG. 5B

600

HARDWARE SYSTEM

PHASE SHIFTER
& ATTENUATION
MODULE

MAGNET
CONTROL

| HALL
PWR | FWD
PWR | REF
PWR | MAG
FIELD |

SIGNAL ACQUISITION MODULE

605

SIGNAL CORRELATION MODULE — 610

TRANSFORMATION MODULE — 615

SIGMA (.SIG) FILE — 625

SPECTRUM ANALYSIS MODULE — 630

MOBILITY SPECTRUM OUTPUT FILE — 635

MULTI-CARRIER-FIT FILE — 640

FIG. 6

*Fig. 7*

*Fig. 8*

Fig. 9

EP 1 779 124 B1

EP 1 779 124 B1

*Fig. 10*

Fig. 11

713

Fig. 12

Fig. 13

*Fig. 14*

*Fig. 15*

*Fig. 16*

Fig. 17

EP 1 779 124 B1

*Fig. 18*

*Fig. 19*

EP 1 779 124 B1

**EP 1 779 124 B1**

**REFERENCES CITED IN THE DESCRIPTION**

**Patent documents cited in the description**

- US 4605893 A
- WO 02090922 A2
- US 6711948 B2
- US 6443002 B2